# EUROPÄISCHE PATENTANMELDUNG

(11) **EP 4 683 343 A1**
(43) Veröffentlichungstag der Anmeldung: **21.01.2026**
(21) Anmeldenummer: 25182153.4
(22) Anmeldetag: 11.06.2025
(51) Int. Cl.: H04Q 9/00, H04W 56/00, H03B 5/04, H03L 1/02

(54) **FUNKSENDER**

(30) Priorität: 09.07.2024 DE 102024119501
(71) Anmelder: Diehl Metering Systems GmbH, 90451 Nürnberg (DE); DIEHL METERING SAS, 68304 Saint Louis (FR)
(72) Erfinder: Petkov, Hristo, 90411 Nürnberg (DE); Pfirrmann, Manfred, 90443 Nürnberg (DE); Kauppert, Thomas, 90455 Nürnberg (DE); Wechsler, Johannes, 91174 Spalt (DE); Lautenbacher, Thomas, 91058 Erlangen (DE); Berger, Xavier, 68260 Kingersheim (FR)
(74) Vertreter: Diehl Patentabteilung

(57) **Zusammenfassung**

Die vorliegende Erfindung betrifft einen Funksender (200) für den Betrieb eines Funkübertragungssystems (100), vorzugsweise eines SRD-Funkübertragungssystems, zwischen mindestens einem Funksender (200), vorzugsweise zwischen einer Mehrzahl von Funksender (200), und einem als Basisstation arbeitenden Funkempfänger (300), wobei der jeweilige Funksender (200) zu bestimmten Sendezeiten ein Telegramm in Form eines Datenpakets oder einer Mehrzahl nacheinander versendeten Teildatenpakete an den Funkempfänger (300) jeweils als Burst bzw. Bursts versendet, wobei der jeweilige Funksender (200) einen Quarz (201) aufweist, der eine Schwingung für einen Timer erzeugt, auf Basis welcher der Timer die Start- und/oder Endzeitpunkte der Versendung des jeweiligen Bursts festlegt, wobei der Quarz (201) durch einen Quarzfehlerverlauf (F1) charakterisiert ist, der die originäre Temperaturabhängigkeit des Quarzfehlers des Quarz (201) festlegt. Zur Lösung der Aufgabe, einen Funksender zur Verfügung zu stellen, der eine zeitgenaue Aussendung von Telegrammen auch dann zulässt, wenn dessen Hardware einen Abgleich mit der Übertragungsfrequenz bzw. Trägerfrequenz des Funksignals nicht ermöglicht, sind Kompensationsmittel für den Quarzfehler des Quarzes (201) vorgesehen, die den Quarzfehlerverlauf (F1) verändern, insbesondere verschieben.

## Beschreibung

Die vorliegende Erfindung betrifft einen Funksender für den Betrieb eines Funkübertragungssystems, vorzugsweise eines SRD-Funkübertragungssystems d. h. eines Short Range-Funkübertragungssystems wie z. B. eines Funkübertragungssystems nach der ETSI TS 103 357 V1.1.1 (2018-06) dieser Fassung oder nachfolgender Fassungen, gemäß dem Oberbegriff des Anspruchs 1, vorzugsweise einen Funksender eines intelligenten Verbrauchsmessgeräts.

### Ausgangssituation

Intelligente Verbrauchsmessgeräte, auch Verbrauchsmesser oder Smart Meter genannt, sind in ein Versorgungsnetz eingebundene Verbrauchsmessgeräte z. B. für Wärme bzw. Energie, Strom, Gas, Wasser, die dem jeweiligen Anschlussbenutzer den tatsächlichen Verbrauch anzeigen und in ein Kommunikationsnetz eingebunden sind. Intelligente Verbrauchsmessgeräte haben den Vorteil, dass manuelle Ablesungen der Zählerstände entfallen und seitens des Versorgers kurzfristigere Rechnungstellungen gemäß dem tatsächlichen Verbrauch vorgenommen werden können. Durch kurzfristigere Ableseintervalle ist wiederum eine genauere Kopplung der Endkundentarife an die Entwicklung der Börsenstrompreise möglich. Auch können Versorgungsnetze wesentlich besser ausgelastet werden

Intelligente Verbrauchsmessgeräte sind üblicherweise jeweils Wohneinheiten oder Wohnhäusern zugeordnet. notwendig ist. Das Sammeln der Messdaten per Funk erfolgt durch ortsfeste oder mobile Basisstationen ("Datensammler"), an die die in den Sendern der Verbrauchsmessgeräte bereitgestellten Messdaten übertragen werden.

Aus rechtlichen Gründen dürfen von den Funksendern der Verbrauchsmessgeräte lediglich Messdaten, die zu bestimmten, sehr kurzen Sendezeiträumen (Sendezeit bzw. Sendezeitpunkt inklusive Zeitabweichung) an die Basisstation übertragen werden, für die Verbrauchsauswertung herangezogen werden. Während dieser sehr kurzen Sendezeiträume übertragen die Sender aller Verbrauchsmessgeräte ihre Datenpakete an den Empfänger der Basisstation. Eine Schwierigkeit besteht darin, dass Kommunikationssysteme mit Funkübertragung zwischen Basisstation und Verbrauchsmessgeräten eine sehr genaue Zeitsynchronisation zwischen den im Bereich der Verbrauchsmessgeräte befindlichen Kommunikationsmodulen und demjenigen des Datensammlers benötigen.

Die Übertragungskanäle sind schmalbandig, so dass bestimmte Anforderungen an die Genauigkeit in der Frequenz und in der Zeitbestimmung der beteiligten Geräte zu stellen sind. Die verwendeten Trägerfrequenzen sowie Abtastraten leiten sich in solchen Funkübertragungssystemen typischerweise von Hochfrequenz-Quarzen bzw. Hochfrequenz-Quarzoszillatoren ab. Die zeitlichen Übertragungs-Ereignisse leiten sich von niederfrequenten Schwingquarzen (Quarze), die günstiger sind als Hochfrequenz-Quarze aber einen größeren Fehler aufweisen. Bei der Kommunikation, wie beispielsweise in einem Verbrauchsdatenerfassungssystem bzw. Metering Funknetzwerk bestimmen daher fertigungsbedingte Toleranzen der verwendeten Quarze Abweichungen innerhalb der Zeit zwischen Basisstation und Funksender. Dies kann wiederum zu degradierenden Effekten wie zu einer reduzierten Reichweite oder im schlimmsten Fall zum Abbruch der Kommunikation führen. Gerade im Bereich der Kommunikationsmodule autonomer Verbrauchsmessgeräte werden einfache Quarze mit geringem Stromverbrauch eingesetzt. Derartige Quarze weisen aufgrund von Fertigungstoleranzen, Temperaturverhalten und Alterung Quarzfehler von 10 - 100 ppm auf. Beispielsweise führt bei einem Quarz ein Quarzfehler von 50 ppm zu einer Abweichung von 4,3 Sekunden pro Tag bzw. 26 Minuten pro Jahr.

### Druckschriftlicher Stand der Technik

Aus der DE 10 2005 062 809 A1 ist ein bidirektionales Funkübertragungssystem bekannt, bei dem Endgeräte in der Lage sind, ihre Funksendefrequenz jeweils nach Maßgabe einer zuvor erfassten Übertragungsfrequenz eines Datensammelgerätes möglichst genau anzupassen, so dass eine nächste Funkbotschaft des betreffenden Endgerätes an das Datensammelgerät mit großer Wahrscheinlichkeit exakt in dessen schmales Empfangsband fällt. Hierzu ist das Endgerät dazu eingerichtet ist, bei Empfang eines Funksignals von dem Datensammelgerät dessen aktuelle Übertragungsfrequenz zu erfassen und die eigene Funksendefrequenz für eine Funksendung zum Datensammelgerät nach Maßgabe der erfassten Übertragungsfrequenz einzustellen. Die darin beschriebene Maßnahme kann jedoch nur dann eingesetzt werden, wenn die Hardware des Endgeräts einen solchen Vergleich ermöglicht.

### Aufgabe der vorliegenden Erfindung

Die Aufgabe der vorliegenden Erfindung besteht darin, einen Funksender zur Verfügung zu stellen, der eine zeitgenaue Aussendung von Telegrammen auch dann zulässt, wenn dessen Hardware einen Abgleich mit der Übertragungsfrequenz bzw. Trägerfrequenz des Funksignals nicht ermöglicht.

### Lösung der Aufgabe

Die vorstehende Aufgabe wird durch die Merkmale des Anspruchs 1 gelöst. Zweckmäßige Ausgestaltungen der Erfindung sind in den abhängigen Ansprüchen beansprucht.

Erfindungsgemäß sind Kompensationsmittel vorgesehen, die den Quarzfehlerverlauf also die temperaturabhängige Quarzfehlercharakteristik verändern, insbesondere verschieben, derart, dass der gesamte Quarzfehlerverlauf entlang der Fehlerwert-Achse verschoben wird, so dass sich der Quarzfehler bei einem vorgegebenen (z. B. um den Fehler-Nullpunkt gelegten) Zeitfehlersollbereich über einen größeren Temperaturbereich erstreckt als ohne Anwendung der Mittel. Die Erfindung ermöglicht es somit, bei einem üblicherweise vergleichsweise großen Zeitfehler eines Quarzes des Funksenders ohne Durchführung eines in der DE 10 2005 062 809 A1 vorgeschlagenen Abgleichs mit der Übertragungsfrequenz des Funksignals die Sendezeitpunkte genau zu treffen. Eine Anpassung kann somit auch bei Funksender erfolgen, bei denen keine physikalische Verbindung zwischen einem Quarz und einer Trägerfrequenz gegeben oder möglich ist. Da im Funksender der in der DE 10 2005 062 809 A1 vorgeschlagene Abgleich nicht stattfindet, kann gleichzeitig hierdurch auch der Energieverbrauch im Funksender reduziert werden. Zudem kann durch die Erfindung im Funksender eine vergleichsweise günstige Hardware zum Einsatz kommen.

Gemäß einer Ausgestaltung der Erfindung kann der Quarzfehlerverlauf in positiver und/oder Richtung also in Richtung des positiven und/oder negativen Bereichs des temperaturabhängigen Quarzfehlers verschoben werden. Hierdurch kann der Quarz in einem breiteren Temperaturbereich sowie einem größeren Bereich um den Quarzfehler-Nullpunkt herum eingesetzt werden. Die Verschiebung kann je nach Lage der originäre Temperaturabhängigkeit des Quarzfehlers des Quarzes erfolgen.

Gemäß einer Ausgestaltung der Erfindung kann der Quarzfehlerverlauf um einen Quarzfehler von jeweils maximal ±75 ppm, vorzugsweise bis ±65 ppm, besonders vorzugsweise bis ±55 ppm verschoben werden.

Gemäß einer Ausgestaltung der Erfindung kann die Verschiebung unter Einbeziehung
eines anfänglichen Quarzfehlers bzw. herstellerseitig ausgewiesenen Quarzfehlers des Quarzes, und/oder
eines Fehlers aufgrund eines Agings des Quarzes, und/oder
eines Fehlers aufgrund von parasitären Kapazitäten und/oder Induktivitäten der Leiterplatte und/oder des Chips, und/oder
eines Fehlers aufgrund eines Rundungsfehlers bei der Berechnung des Sendezeitpunkts erfolgen.

Gemäß einer Ausgestaltung der Erfindung kann die Verschiebung durch Anpassung der Hardware und/oder durch Anpassung der Firmware erfolgen. Bei Anpassung der Firmware d. h. durch Anpassung mittels softwaretechnischen Maßnahmen bzw. mittels Berechnung kann die Hardware beibehalten werden. Dies ist vorteilhaft, da durch Anpassung der Hardware andere Komponenten des Systems, die ebenfalls den Quarz verwenden, beeinflusst werden könnten. Mittels der Anpassung durch die Firmware kann der Sendezeitpunkt an die erforderliche Toleranz angepasst werden, ohne dass Hardwarekomponenten verändert werden müssen.

Gemäß einer Ausgestaltung der Erfindung kann die Verschiebung unter Anwendung eines Umrechnungsfaktors (Korrekturfaktors) auf Basis des Taktimpulses eines Timers der Steuer- und Recheneinheit, aus dem die Start- und/oder Endzeitpunkte für die Bursts für die Telegramme bzw. die Teildatenpakete generiert werden. Die Verschiebung erfolgt somit auf Basis einer rechnerischen Kompensation des Quarzfehlers. Dies ist besonders einfach umzusetzen, da der Timer der Steuer- und Recheneinheit, also des Mikrokontroller, die Start- und/oder Endzeitpunkte für die Bursts aus der Schwingung des Quarzes bzw. des Oszillators generiert.

Gemäß einer Ausgestaltung der Erfindung kann der Umrechnungsfaktor die Umrechnung der Dauer eines Taktimpulses in einen Zeitwert betreffen. Bei dem Umrechnungsfaktor kann es sich insbesondere um einen, vorzugsweise gerundeten, Teiler handeln, der aus der Zeitdauer (z. b. in Nanosekunden) eines Taktimpulses resultiert.

Gemäß einer Ausgestaltung der Erfindung kann die Festlegung des Betrags der Verschiebung durch Auswahl eines Umrechnungsfaktors aus einer Mehrzahl von z. B. in einem Speicher hinterlegten Umrechnungsfaktoren erfolgen. Verschiedene Umrechnungsfaktoren stehen somit für unterschiedliche Kompensationen des Quarzfehlers. Insbesondere können verschiedene vorgenannte Teiler als Umrechnungsfaktor hinterlegt sein

Gemäß einer Ausgestaltung der Erfindung kann die Auswahl des Umrechnungsfaktors, vorzugsweise auch während des Betriebs, aus der Mehrzahl von unterschiedlichen Umrechnungsfaktoren in Abhängigkeit des, vorzugsweise aktuellen, Quarzfehlers des Quarzes erfolgen.

Gemäß einer Ausgestaltung der Erfindung kann der Quarzfehler des zu verwendenden Quarzes des Funksenders gemessen oder geschätzt werden. Auf Basis dieser Messung oder Schätzung kann die Größe der Verschiebung festgelegt werden.

Gemäß einer Ausgestaltung der Erfindung kann die Anwendung des Umrechnungsfaktors also die Kompensation für den Startzeitpunkt und/oder den Endzeitpunkt eines Bursts. Bei einzelnen Bursts kann der Umrechnungsfaktor bei nachfolgenden Bursts an einen sich ergebenden Fehlerdrift angepasst werden.

Gemäß einer Ausgestaltung der Erfindung kann die Versendung der jeweiligen Bursts im Schmalbandbereich, vorzugsweise in einem ISM Band, besonders vorzugsweise im 868 MHz Frequenzband erfolgen. Gerade in diesen Frequenzbändern ist die Anwendung der Erfindung besonders attraktiv, da dort eine Vielzahl von energetisch sensiblen Anwendungen betrieben werden.

Gemäß einer Ausgestaltung der Erfindung kann die nacheinander erfolgende Versendung von Teildatenpakete betreffenden Bursts über unterschiedliche Frequenzen erfolgen. Derartig versendete Telegramme bzw. Datenpakete sind weniger störanfällig.

Gemäß einer Ausgestaltung der Erfindung kann das versendete Telegramm einen Core-Frame aufweisen, der aus mindestens 24 Bursts oder genau 24 Bursts besteht. Derartige Uplink-Telegramme werden im Rahmen der der ETSI TS 103 357 V1.1.1 (2018-06) dieser Fassung oder nachfolgender Fassungen eingesetzt. Die Erfindung erlaubt es somit, den Funksender auch für ein solches Funkübertragungsverfahren zu nutzen, wie es in der vorgenannten Norm einschließlich in einer nachfolgenden Fassung festgelegt ist.

Gemäß einer alternativen Ausgestaltung der Erfindung kann das versendete Telegramm bzw. Paket aus drei einzeln decodierbaren Bursts bestehen oder diese umfassen, insbesondere wobei jeder Burst die insbesondere gleiche Payload-Information unterschiedlich kodiert enthält. Die vorliegende Erfindung ist auch für ein solches Funkübertragungsverfahren von besonderem Nutzen.

Gemäß einer Ausgestaltung der Erfindung kann als eine autarke Energiequelle eine Batterie, vorzugsweise eine Longlife-Batterie vorgesehen sein. Eine solche Longlife-Batterie ist durch eine Standzeit "im Feld" von mindestens 10 Jahren gekennzeichnet.

Gemäß einer Ausgestaltung der Erfindung kann der Quarz eine Frequenz von 32768 kHz haben. Hierbei handelt es sich um gängige günstige Uhrenquarze, die für die vorliegende Anwendung aufgrund der Erfindung zum Einsatz kommen können.

Gemäß einer Ausgestaltung der Erfindung kann der Quarz ein nicht temperaturkompensierter Quarzoszillator sein. Über den Temperaturbereich tritt bei derartigen Quarzoszillatoren eine vergleichsweise starke Abweichung des Fehlers in den -ppm Bereich auf. Derartige Quarzoszillatoren sind unter Produktionskostengesichtspunkten besonders interessant.

### Beschreibung der Erfindung anhand von Ausführungsbeispielen

Zweckmäßige Ausgestaltungen der vorliegenden Erfindung werden nachstehend anhand von Zeichnungsfiguren näher erläutert. Gleichbleibende Merkmale sind hierbei der Übersichtlichkeit halber lediglich einmal mit einem Bezugszeichen versehen. Es zeigen:
- Fig. 1: ein Funkübertragungssystem mit einer Mehrzahl von Funksendern gemäß einem Beispiel der vorliegenden Erfindung in stark vereinfachter schematischer Darstellungsweise;
- Fig. 2: einen beispielhaften Quarzfehlerverlauf eines Quarzes für einen Timer eines erfindungsgemäßen Funksenders;
- Fig. 3: Beispiele von gemäß der Erfindung verschobenen Quarzfehlerverläufen sowie
- Fig. 4: eine vergleichende Darstellung eines Beispiels einer Verschiebung des Versende Startpunkts eines Bursts z. B. in positiver Richtung.

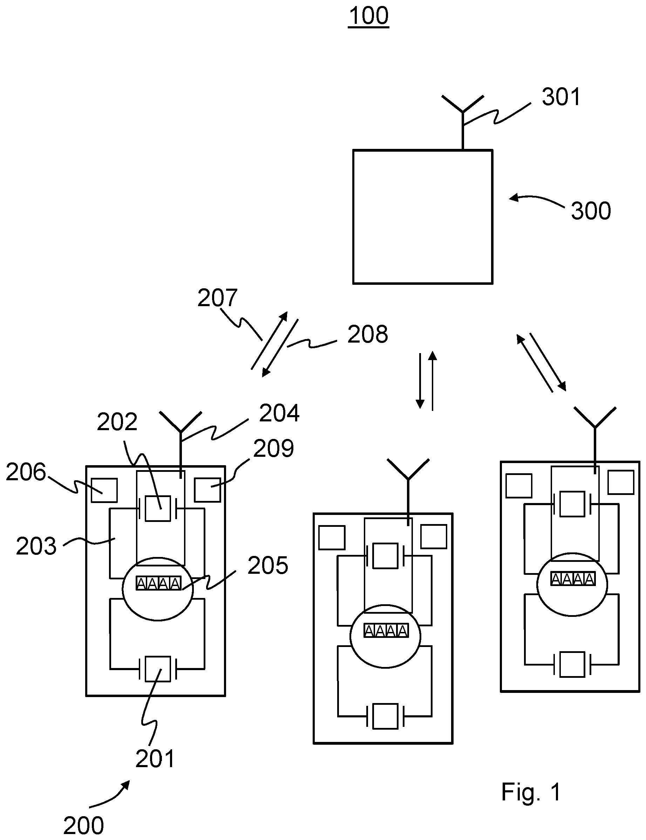

Bezugsziffer 100 in Fig. 1 zeigt ein Funkübertragungssystem, bei der eine Mehrzahl von Funksendern 200 mit einem Funkempfänger 300 in Form eines Datensammlers oder einer Basisstation miteinander kommunizieren.

Jeder Funksender 200 verfügt hierzu über ein Kommunikationsmodul 203 mit Antenne 204 sowie einem Frequenz-Quarz 202, welche die Trägerfrequenz für als Bursts auszusendende Telegramme 207 (Datenpakete) erzeugt. Ferner verfügt der Sender 200 über eine Steuer- und Recheneinheit 206 (Mikrokontroller) sowie eine autarke Energiequelle in Form einer Batterie 209, insbesondere einer sogenannten Langzeitbatterie. Letztere stellt einen Betrieb des Funksenders 200 über einen vergleichsweise langen Zeitraum, z. B. über mindestens zehn Jahre, im Feld sicher. Der Funksender 200 kann zudem, bei Bedarf, über eine Anzeige 205 in Form eines Displays verfügen.

Ferner verfügt der Funksender 200 über einen Quarz 201, mittels dem ein (in Fig. 1 nicht dargestellter) Oszillator des Funksenders 200 eine Schwingung, z. B. 32768 kHz, erzeugt. Die Schwingung taktet einen Hardware-Timer in der Steuer-und Recheneinheit 206. Aus dem Hardware-Timer werden die Startzeiten der Versendung der Bursts zur Übermittlung eines Telegramms 207 im Uplink zu dem Funkempfänger 300 generiert. Derartige Funksender 200 versenden Telegramme 207 z. B. zu festen Sendezeiten (z. B. jeden Tag um 12:00 Uhr) oder zu beliebigen oder pseudozufälligen Sendezeiten, zu denen der Funkempfänger 300 jeweils ein Empfangsfenster öffnet. Nach Übertragung der Telegramme 207 wird das Empfangsfenster im Funkempfänger 300 wieder geschlossen.

Vorzugsweise handelt es sich bei dem Funkübertragungssystem um ein solches, bei dem eine Versendung der jeweiligen Telegramme 207 in einem Schmalbandbereich, vorzugsweise in einem ISM Band, besonders vorzugsweise im 868 MHz Frequenzband an den Funkempfänger 300 erfolgt. Zur Erhöhung der Robustheit der Übertragung können einzelne Telegramme 207 oder Datenpakete in einzelne Teildatenpakete aufgetrennt werden, die nacheinander als einzelne Bursts, vorzugsweise über unterschiedliche Frequenzen, versendet werden.

Insbesondere werden Uplink-Telegramme im Rahmen einer Übertragung gemäß der ETSI TS 103 357 v 1.1.1 (2018-06) auf diese Weise übertragen. Ein Telegramm weist hierbei einen Core-Frame auf, der aus 24 einzelnen Teildatenpaketen (Bursts) besteht. Hierdurch kann eine erhöhte Robustheit der Übertragung erzielt werden.

Gemäß einer alternativen Spezifikation kann ein versendetes Telegramm bzw. Paket auch aus drei einzeln decodierbaren Bursts bestehen oder diese umfassen, wobei jeder Burst die insbesondere gleiche Payload-Information unterschiedlich kodiert enthält.

Bei dem bereits zuvor beschriebenen Quarz 201 handelt es sich typischerweise um einen Uhrenquarz, der als Massenprodukt zu einem günstigen Preis verfügbar ist, jedoch einen vergleichsweise hohen Quarzfehler von ca. ± 20 ppm aufweist. Bei dem Quarz handelt es sich vorzugsweise um einen 32768 kHz Quarz. Vorzugsweise ist der Quarz ein nicht temperaturkompensierter Quarz.

Demgegenüber ist der Frequenz-Quarz 202 höherwertig mit einem durchschnittlichen Fehler von ca. ± 2 ppm. Dafür ist es allerdings auch wesentlich teurer. Damit die Übertragungszeiten trotz des vergleichsweise hohen Quarzfehlers des Quarzes 201 sicher getroffen werden, erfolgte bei bisherigen Anwendungen eine Synchronisation der quarzfehlerbehafteten Sendezeiten über den Frequenz-Quarz 202 des Funksenders gemäß der DE 10 2005 062 809 A1. Eine solche Synchronisation ist jedoch abhängig von der Hardware des Funksenders 200 und damit nicht immer möglich.

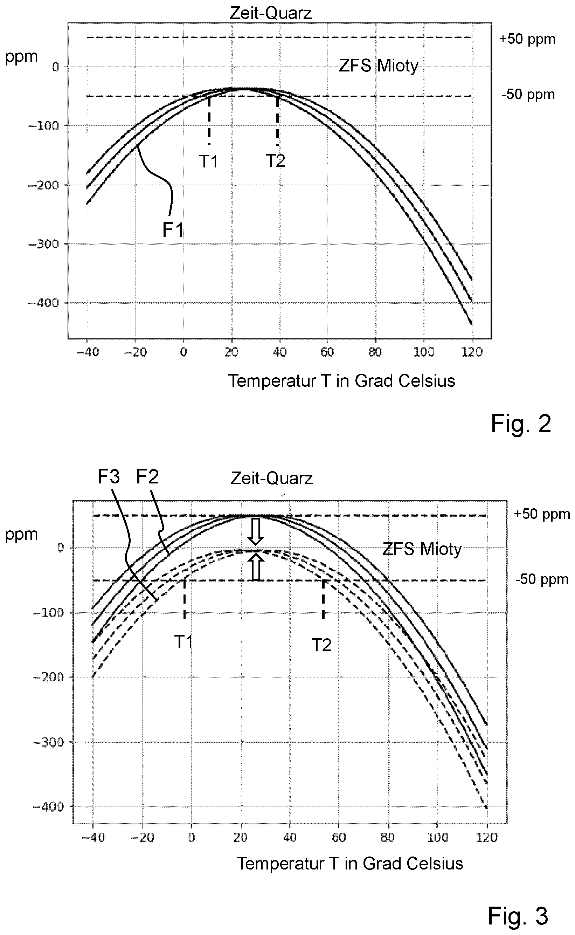

Fig. 2 zeigt ein Beispiel eines originären Quarzfehlerverlaufs des Quarzes 201 des Funksenders 200 von Fig. 1 als Diagramm des Quarzfehlers in ppm gegenüber der Temperatur T in Grad Celsius. Derartige Kurven werden von dem jeweiligen

Hersteller der Quarze zur Verfügung gestellt. Die drei Kurven stehen für den Minimalverlauf, den Maximalverlauf sowie den typischen Verlauf des Fehlers über der Temperatur.

In Fig. 2 ist als Beispiel der Quarzfehlerbereich ZFS MIOTY dargestellt, welcher für eine Anwendung in einem Funkübertragungssystem gemäß dem vorgenannten Standard erfüllt sein muss. Er liegt zwischen -50 ppm und +50 ppm. Die beiden horizontalen gestrichelten geraden Linien in Fig. 2 legen den Quarzfehlerbereich ZFS in ppm fest, in dem noch keine Degradation der Leistung für MIOTY auftritt. Wie der Fig. 2 entnommen werden kann, erfüllt der Quarz von Fig. 2 die Erfordernisse nur in einem sehr kleinen Temperaturbereich von ca. +10°C bis +40 °C. Der Temperatureffekt bzw. Fehler des Quarzes verläuft außerhalb dieses Bereichs in eine negative Richtung. Je höher und tiefer die Temperatur ist, desto größer wird der negative Fehler. Ohne eines Abgleichs des Fehlers des Quarzes 201 mithilfe des Frequenz-Quarzes 202 des Kommunikationsmoduls 203 wäre der in Fig. 2 gezeigte Quarz für eine Anwendung in einem solchen Funkübertragungssystem nicht geeignet.

Die vorliegende Erfindung sieht vor, Kompensationsmittel für den Quarzfehler eines Quarzes 201 vorzusehen, die den Quarzfehlerverlauf F1 derart verändern bzw. verschieben, dass dieser über einen größeren Bereich seines Verlaufs innerhalb des für das betreffende Funkübertragungssystem 100 erforderlichen Quarzfehlerbereichs liegt.

Folgende Einflussparameter auf den Zeitfehler eines Quarzes können berücksichtigt werden:

**Tabelle 1: Einflussparameter auf den Zeitfehler eines Quarzes**

| **Einflussparameter** | **Wert** |
|---|---|
| Anfängliche Zeitfehlertoleranz | ± 20 ppm |
| Alterung | ± 6 ppm (bei einer Laufzeit von 6 Jahren |
| PCB-+Chip-+Last-(kapazitive und/oder induktive)-Toleranzen | ± 7 ppm |
| Rundungsfehler (Burstzeitberechnung) | ± 13,8 ppm |

Die anfängliche Zeitfehlertoleranz von ± 20 ppm ist bedingt durch die Qualität des Uhrenquarzes und seine Bearbeitung bzw. Herstellung. Bei der Alterung handelt es sich um eine alterungsbedingte Änderung des Quarzes und damit seines Quarzfehlers über der Zeit. Der Quarzfehler liegt bei einem Uhrenquarz gemäß der Tabelle 1 bei einer angenommenen Laufzeit von 6 Jahren bei ca. ± 6 ppm. Zusätzliche Toleranzen des Uhrenquarzes resultieren von Toleranzen der Leiterplatte (PCB), des Chips (einschließlich Verdrahtungen) sowie von Last-(kapazitiven und/oder induktiven) Toleranzen des Oszillators (Pierce Oszillator) einschließlich diesbezüglicher parasitärer Kapazitäten und Induktivitäten.

Eine Adaption des Quarzfehlerverlaufs ohne Abgleich mit der Trägerfrequenz des frequenzgenaueren Frequenz-Quarzes 202 kann gemäß der vorliegenden Erfindung durch eine Anpassung der Hardware und/oder der Firmware (also des Steuerprogramms) des Funksenders erfolgen. Mögliche Kompensationsmittel für die Hardware sind der Einsatz eines Quarzes mit einer geringfügig unterschiedlichen anfänglichen Zeitfehlertoleranz bzw. Frequenz. Zusätzlich oder anstelle davon können auch die Werte der Kapazitäten und/oder Induktivitäten in dem Oszillatorkreis (Pierce-Oszillator) mittels geeigneter Hardware angepasst werden.

Bei Anpassung der Firmware berechnet die Software das Timing des Versendens des jeweiligen Bursts durch Hinzufügen eines zusätzlichen Offsets zum Sendezeitpunkt des betreffenden Bursts. Der Funksender fügt einfach einen zeitlichen Korrekturfaktor, also einen zeitlichen Offset, zu dem Sendezeitpunkt eines Bursts hinzu.

Um den richtigen Wert des Korrekturfaktors zu finden, wird der Wert der parasitären Kapazitäten und/oder Induktivitäten auf dem PCB gemessen und die Toleranzen des Chips und der PCB in Plus- oder Minusrichtung hinzugefügt. Bezugnehmend auf das obige Beispiel gemäß Fig. 1 sollte der Fehler in positiver Richtung einen Wert von +50 ppm nicht übersteigen. Die variablen Toleranzen betragen ± 26 ppm (± 20 ppm + 6 ppm). Daraus resultiert unter Einbeziehung der PCB-+Chip-+Last-(kapazitiven und/oder induktiven)-Toleranzen eine Verschiebung von +50 ppm - 26 ppm - 7 ppm = +17 ppm. Wird der Quarzfehlerverlauf um +17 ppm also um 17 ppm gemäß dem vertikalen Pfeil in Plusrichtung verschoben, zeigt sich ein Quarzfehlerverlauf F3, wie er in Fig. 3 dargestellt ist. Die drei gestrichelten Linienverläufe liegen über einem breiteren Temperaturbereich innerhalb des Quarzfehlerbereichs ZFS als im Falle der Kurve gemäß Fig. 2. Ein solcher Quarz kann somit trotz des schmalen Fehlerbereichs z. B. für ein MIOTY Funkübertragungssystem verwendet werden, ohne dass ein Abgleich über die Trägerfrequenz des Frequenzquarzes erfolgen muss. Ein Verändern bzw. Verschieben kann gemäß Fig. 3 auch von einem Quarzfehlerverlauf F2 gemäß den durchgezogenen Linien gemäß dem vertikalen Pfeil hin zu einem Verlauf F3 gemäß den gestrichelten Linien erfolgen.

Nachstehend wird ein Beispiel einer Firmware-bezogenen Verschiebung näher beschrieben. Diese ist vorteilhaft, da die Hardware nicht geändert werden muss. Eine Änderung könnte der Hardware auch andere Komponenten nachteilig beeinflussen, die denselben Quarz nutzen. Beispielsweise besteht bei MIOTY der Core-Frame eines Telegramms aus insgesamt 24 Bursts oder mindestens 24 Bursts. Die Bursts werden vom Funksender in einer Genauigkeit im Nanosekundenbereich erzeugt.

Zur Gewährleistung der Verschiebung wird ein Umrechnungsfaktor (Korrekturfaktor) auf Basis der zeitlichen Dauer eines Taktimpulses des Timers ermittelt. Ein Taktimpuls entspricht einer Zeitdauer von 30517,578125 Nanosekunden (ns). Daraus resultiert durch Rundung ein Umrechnungsfaktor von 30517. Ein Umrechnungsfaktor von 30517 wird verwendet, um von Nanosekunden in 32768 Hz Taktimpulsen umzuwandeln.

Wird der Umrechnungsfaktor verändert, werden auch alle Zeitpositionen des Bursts verändert. In einer weiteren Messung werden als Umrechnungsfaktor 30518 verwendet. Beide Werte 30517 sowie 30518 liegen nahe am optimalen Wert. Hierbei sieht man keinen größeren Effekt. Beispielsweise kann man annehmen, dass die Zeit eines Bursts 2.25 s also 2 250 000 000 ns beträgt. Teilt man die Zeit des Bursts durch den Umrechnungsfaktor 30517, ergibt dies eine Anzahl von 73729 Taktimpulsen pro Burst. Teilt man die Zeit des Bursts durch den Umrechnungsfaktor 30518, ergibt dies eine Anzahl von 73726 Taktimpulsen/Burst. Ein höherer Umrechnungsfaktor (Korrekturfaktor) resultiert in einer kürzeren Burstzeitspanne.

Liegt der Quarz im - ppm Bereich, dann schwingt der Quarz langsamer als in der realen Zeit. Schwingt der Quarzes langsamer, dann sendet der Funksender zu einem späteren Zeitpunkt als zur realen Zeit aus. Die vorliegende Erfindung macht sich diesen Gesichtspunkt zunutze. Wird die Zeiterfassung auf Basis des Quarzes künstlich verschoben, z. B. in eine positive Richtung also hin in Richtung zu einem kleineren Fehler, bedeutet dies, dass der Sendezeitpunkt wieder etwas schneller erreicht wird als vor der Kompensation. Um in die positive Richtung zu verändern bzw. zu verschieben, muss der Umrechnungsfaktor erhöht werden also ein höherer Umrechnungsfaktor verwendet werden.

Die Umrechnungsfaktoren 30517 sowie 30518 ergeben bereits gute Werte für eine Anpassung. Betrachtet man eine Sekunde und teilt diese Zeitspanne durch die Anzahl von Nanosekunden für einen Taktimpuls ergeben sich 32768,62 Taktimpulse für den 30517 Umrechnungsfaktor Sekunde (1 000 000 000 ns/30517 = 32768,62 Taktimpulse). Dies entspricht einer Verschiebung um -18,9 ppm (32768/32768,62 = 0,99998107). Ein Umrechnungsfaktor von 30518 anstatt 30517 ergibt eine Verschiebung in positiver Richtung um +13,8 ppm. Der Umrechnungsfaktor 30518 ergibt 32767,547 Taktimpulse pro Sekunde (1 000 000 000 ns/30518 = 32767,547 Taktimpulse). 32768 Taktimpulse / 32767,547 Taktimpulse ergibt 1,0000138. Dies entspricht einer Verschiebung um +13,8 ppm.

Nachstehend sind exemplarisch einige Umrechnungsfaktoren und die zugehörigen Verschiebungen aufgelistet:

**Tabelle 2: Verschiedene Verschiebungen des Quarzfehlerverlaufs in Abhängigkeit des Umrechnungsfaktors**

| **Umrechnungsfaktor** | **Taktimpulse Timer** | **Verschiebung in ppm** |
|---|---|---|
| 30517 | 32768,62 | -18,9 ppm |
| 30518 | 32767,547 | +13,8 ppm |
| 30519 | 32766,43 | +47,9 ppm |
| 30520 | 32765,399 | +79,3 ppm |

In der Firmware des Funksenders können unterschiedliche Umrechnungsfaktoren für die zugehörigen Verschiebungen auswählbar hinterlegt sein, so dass der Quarzfehlerverlauf des betreffenden Quarzes eines Funksenders optimiert an den erforderlichen Quarzfehlerbereich ZFS angepasst werden kann. Entsprechende Umrechnungsfaktoren können beispielsweise in einem Speicher oder Lookup-Table in der Steuer-und Recheneinheit des Funksenders abgelegt sein und je nach Bedarf ausgelesen werden.

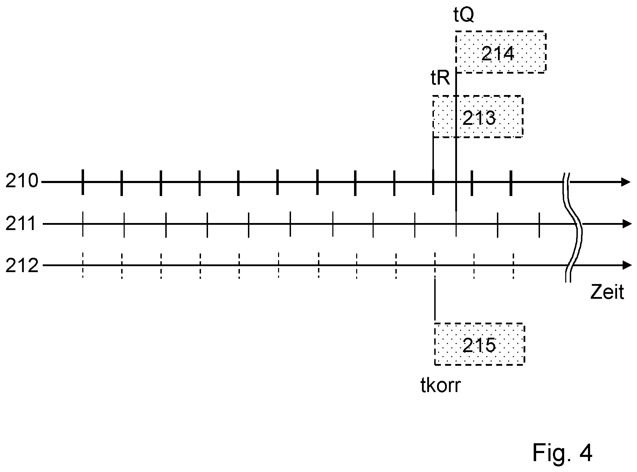

Die Zeitachse 210 in Fig. 4 zeigt die Realzeit. Unter Annahme der Realzeit würde der Startpunkt der Aussendung eines Bursts 213 z. B. bei tR liegen. Die Bezugsziffer 211 zeigt die Zeitachse mit dem Takt des Timers bzw. Quarzes ohne Kompensation. Der Quarz läuft langsamer als die Realzeit. Der Startzeitpunkt des Bursts 214 würde bei TQ liegen, also liegt um einiges später. Die Bezugsziffer 212 zeichnet die Zeitachse mit dem Takt nach einer Verschiebung gemäß der Erfindung um einen Umrechnungsfaktor bzw. Korrekturfaktor in positive Richtung. Aufgrund des Umrechnungsfaktors würde der Timer des Funksenders den Startpunkt des Bursts 215 auf tkorr legen. Dieser liegt wesentlich näher an dem Startpunkt tR. Ein nicht dargestellter Endzeitpunkt des Bursts würde sich entsprechend verschieben.

### BEZUGSZEICHENLISTE

- 100: Funkübertragungssystem
- 200: Funksender
- 201: Quarz
- 202: Frequenz-Quarz
- 203: Kommunikationsmodul
- 204: Antenne
- 205: Anzeige
- 206: Steuer- und Recheneinheit
- 207: Telegramm (uplink)
- 208: Telegramm (downlink)
- 209: Batterie
- 210: Takt in Realzeit
- 211: Takt mit originärem Quarzfehler
- 212: Takt nach Verschiebung in positiver Richtung um Umrechnungsfaktor
- 213: Burst bei tQ
- 214: Burst bei tR
- 215: Burst bei tkorr

- 300: Funkempfänger
- 301: Antenne

- F1: originärer Quarzfehlerverlauf
- F2: verschobener Quarzfehlerverlauf
- F3: verschobener Quarzfehlerverlauf
- ZFS: Quarzfehlerbereich (z. B. für Mioty)

## Patentansprüche

1. Funksender (200) für den Betrieb eines Funkübertragungssystems (100), vorzugsweise eines SRD-Funkübertragungssystems, zwischen mindestens einem Funksender (200), vorzugsweise zwischen einer Mehrzahl von Funksender (200), und einem als Basisstation arbeitenden Funkempfänger (300), wobei der jeweilige Funksender (200) ein Telegramm in Form eines Datenpakets als Burst oder einer Mehrzahl nacheinander jeweils als Burst versendeter Teildatenpakete an den Funkempfänger (300) versendet,
wobei der jeweilige Funksender (200) einen Quarz (201) aufweist, auf Basis dessen die Startzeit der Versendung des jeweiligen Bursts generiert wird,
wobei der Quarz (201) durch einen Quarzfehlerverlauf (F1) charakterisiert ist, der die originäre Temperaturabhängigkeit des Quarzfehlers des Quarzes (201) festlegt, **dadurch gekennzeichnet, dass**
Kompensationsmittel für den Quarzfehler des Quarzes (201) vorgesehen sind, die den Quarzfehlerverlauf (F1) verändern, insbesondere verschieben.

2. Funksender nach Anspruch 1, **dadurch gekennzeichnet, dass** der Quarzfehlerverlauf (F1) in positiver und/oder negativer Richtung des Quarzfehlers des Quarzes (201) verschoben wird.

3. Funksender nach mindestens einem der vorhergehenden Ansprüche, **dadurch gekennzeichnet, dass** die Verschiebung unter Einbeziehung
eines anfänglichen Quarzfehlers bzw. herstellerseitig ausgewiesenen Quarzfehlers des Quarzes (201), und/oder
eines Fehlers aufgrund eines Agings des Quarzes (201), und/oder eines Fehlers aufgrund von parasitären Kapazitäten (und/oder Induktivitäten) der Leiterplatte und/oder des Chips, und/oder
eines Fehlers aufgrund eines Rundungsfehlers bei der Berechnung des Sendezeitpunkts
erfolgt.

4. Funksender nach mindestens einem der vorhergehenden Ansprüche, **dadurch gekennzeichnet, dass** die Verschiebung durch Anpassung der Hardware und/oder durch Anpassung der Firmware erfolgt.

5. Funksender nach mindestens einem der vorhergehenden Ansprüche, **dadurch gekennzeichnet, dass** die Verschiebung unter Anwendung eines Umrechnungsfaktors auf Basis des Taktimpulses eines auf dem Quarz (201) basierten Timers erfolgt.

6. Funksender nach Anspruch 5, **dadurch gekennzeichnet, dass** der Umrechnungsfaktor die Umrechnung der Dauer eines Taktimpulses in einen Zeitwert betrifft.

7. Funksender nach Anspruch 5 oder 6, **dadurch gekennzeichnet, dass** die Festlegung des Betrags der Verschiebung durch Auswahl eines Umrechnungsfaktors aus einer Mehrzahl von unterschiedlichen Umrechnungsfaktoren erfolgt.

8. Funksender nach Anspruch 7, **dadurch gekennzeichnet, dass** die Auswahl eines Umrechnungsfaktors aus der Mehrzahl von unterschiedlichen Umrechnungsfaktoren in Abhängigkeit des Quarzfehlers des Zeit-Quarzes (201) erfolgt.

9. Funksender nach mindestens einem der vorhergehenden Ansprüche, **dadurch gekennzeichnet, dass** die Anwendung des Umrechnungsfaktors für den Startzeitpunkt und/oder den Endzeitpunkt eines Bursts erfolgt.

10. Funksender nach mindestens einem der vorhergehenden Ansprüche, **dadurch gekennzeichnet, dass** die Versendung der jeweiligen Bursts im Schmalbandbereich, vorzugsweise in einem ISM Band, besonders vorzugsweise im 868 MHz Frequenzband erfolgt.

11. Funksender nach mindestens einem der vorhergehenden Ansprüche, **dadurch gekennzeichnet, dass** die nacheinander erfolgende Versendung von Teildatenpakete betreffenden Bursts über unterschiedliche Frequenzen erfolgt.

12. Funksender nach mindestens einem der vorhergehenden Ansprüche, **dadurch gekennzeichnet, dass** das versendete Telegramm einen Core-Frame aufweist, der aus mindestens 24 Bursts oder 24 Bursts besteht oder das versendete Telegramm aus drei einzeln decodierbaren Bursts besteht oder diese umfasst, wobei jeder Bursts die Payload-Information unterschiedlich kodiert enthält.

13. Funksender nach mindestens einem der vorhergehenden Ansprüche, **dadurch gekennzeichnet, dass** als Energiequelle eine Batterie, vorzugsweise eine Longlife-Batterie vorgesehen ist.

14. Funksender nach mindestens einem der vorhergehenden Ansprüche, **dadurch gekennzeichnet, dass** der Quarz (201) eine Frequenz von 32768 kHz hat.

15. Funksender nach mindestens einem der vorhergehenden Ansprüche, **dadurch gekennzeichnet, dass** der Quarz (201) ein nicht temperaturkompensierter Quarzoszillator ist.
